# EUROPÄISCHE PATENTSCHRIFT

(11) **EP 0 637 522 B1**
(45) Veröffentlichungstag und Bekanntmachung des Hinweises auf die Patenterteilung: **15.10.1997**
(21) Anmeldenummer: 94111359.9
(22) Anmeldetag: 21.07.1994
(51) Int. Cl.: B60K 5/04, B60R 21/00

(54) **Anordnung eines Antriebsmotors eines Kraftwagens**
Arrangement of a car engine
Arrangement du moteur d'entraînement d'un véhicule

(30) Priorität: 06.08.1993 DE 4326396
(43) Veröffentlichungstag der Anmeldung: 08.02.1995
(73) Patentinhaber: DAIMLER-BENZ AKTIENGESELLSCHAFT, 70567 Stuttgart (DE)
(72) Erfinder: Gürtler, Dieter, Dipl.-Ing., D-70563 Stuttgart (DE); Ellenrieder, Gunther, Dipl.-Ing., D-73760 Ostfildern (DE)

(56) Entgegenhaltungen:
- EP-A- 0 196 871
- DE-A- 1 630 968
- DE-A- 2 152 136
- DE-A- 2 402 163
- FR-A- 2 670 737
- US-A- 3 743 347
- KRAFTHAND, Nr.1/2, 22. Januar 1994, BAD WORISHOFEN, DE Seiten 20 - 24, XP000417555 'Leichtbau ja, aber'

## Beschreibung

Die Erfindung betrifft eine Anordnung eines in einem Kraftwagen eingebauten Antriebsmotors, bei der der Antriebsmotor in Fahrtrichtung um einen spitzen Winkel gegen die Horizontale nach unten geneigt eingebaut und über vordere und hintere Motorlager mit dem Fahrzeug verbunden ist, wobei die Motorlager so ausgebildet bzw. dimensioniert sind, daß bei einem Frontalaufprall der Antriebsmotor unter Zerstörung der hinteren Motorlager eine geführte Ausweichbewegung zur Fahrbahn hin ausführt und dem Antriebsmotor ein nach hinten unten weisender Bereich einer Stirnwand zugeordnet ist.

Ein im Aufprallfall derart ausweichender Antriebsmotor ist durch die DE-A-2152136 bekannt, wobei an dem in einem Bogen nach hinten unten weisenden Abschnitt der Stirnwand sich der Antriebsmotor über eine beidendig gelenkig gelagerte Führungsschwinge abstützt, so daß bei einem Frontalaufprall nach dem Brechen der am angeflanschten Getriebe tunnelseitig als Sollbruchstelle ausgebildeten Lagerung der Antriebsmotor eine durch die Führungsschwinge aufgezwungene, auf einem Kreisbogen liegende Ausweichbewegung nach unten ausführt, bei der das Getriebe unter die formsteife Insassenzelle geführt wird.

Es ist Aufgabe der Erfindung, einen Antriebsmotor eines Kraftwagens so anzuordnen, daß auch bei extrem geringer Vorbaulänge bei einem Frontalaufprall keine Blockbildung eintritt und die gesamte Vorbaulänge zur Leistung von Deformationsarbeit zur Verfügung steht.

Diese Aufgabe wird durch die Merkmale des Patentanspruches 1 gelöst.

Besonders vorteilhafte Ausgestaltungen der Erfindung sind den weiteren Patentansprüchen zu entnehmen.

Der Gegenstand der Erfindung soll im folgenden anhand in der Zeichnung dargestellter Ausführungsbeispiele näher erläutert werden.

In der Zeichnung zeigen:
- Fig. 1: einen Schnitt in einer Mittellängsebene durch einen Kraftwagenvorbau, wobei der Antriebsmotor unter Zwischenschaltung eines Hilfsrahmens am Fahrzeug befestigt ist,
- Fig. 2: die Darstellung nach Fig. 1 nach einem Frontalaufprall,
- Fig. 3: eine Draufsicht auf die Darstellung nach Fig. 1,
- Fig. 4: eine Darstellung entsprechend Fig. 1, jedoch mit direkt am Fahrzeug befestigtem Antriebsmotor, und
- Fig. 5: den Schnitt nach der Linie V-V in Fig. 1.

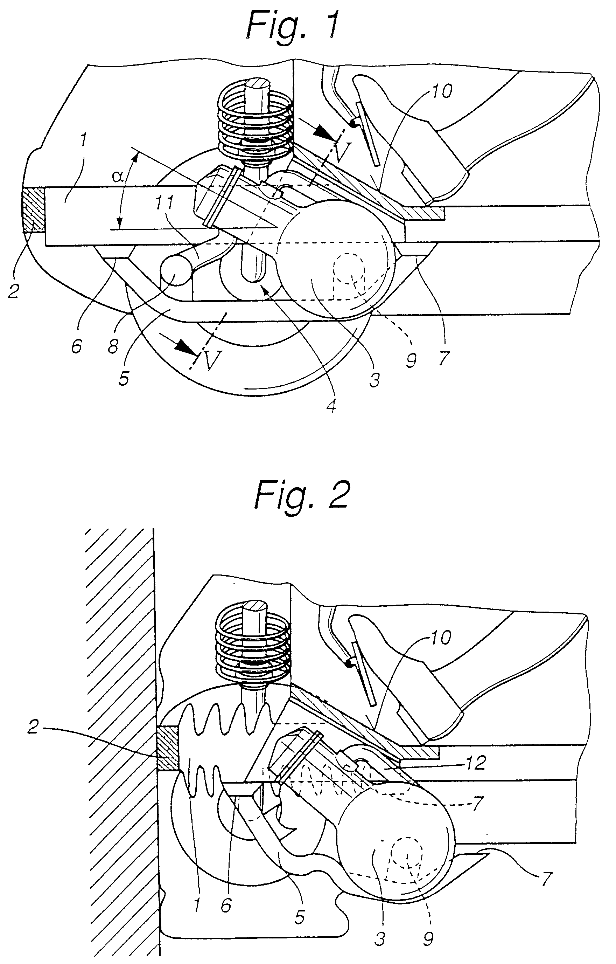

Der in den Fig. 1 bis 3 der Zeichnung teilweise dargestellte Vorbau eines Kraftwagens weist Vorbaulängsträger 1 auf, denen ein zusätzliches Deformationselement 2 vorgeschaltet ist. Ein Antriebsmotor 3 in Form eines quer eingebauten Hubkolbenmotors ist unter einem Winkel α von etwa 30° zur Horizontalen geneigt derart angeordnet, daß er sich mit wesentlichen Bereichen hinter der Vorderachse 4 erstreckt und nur Teile der Zylinder oberhalb der Vorderachse 4 liegen.

Am Fahrzeug befestigt ist der Antriebsmotor 3 unter Zwischenschaltung eines Hilfsrahmens 5, der an zwei Lagerstellen 6 und 7 mit dem Vorbaulängsträger 1 verbunden ist. Auf dem Hilfsrahmen 5 gehalten ist der Antriebsmotor über vordere Lager 8 und hintere Lager 9.

Unter dem gleichen Winkel α, unter dem der Antriebsmotor 3 zur Horizontalen geneigt ist, verläuft benachbart zu diesem eine von einem Bereich der Stirnwand gebildete steife Gleitfläche 10.

Bei einem Frontalaufprall, dessen Folgen in Fig. 2 der Zeichnung dargestellt sind, wird der Vorbaulängsträger 1 verkürzt und die hintere Lagerstelle 7 des Hilfsrahmens 5 am Vorbaulängsträger 1 zerstört, während die vordere Lagerstelle 6 intakt bleibt.

Das vordere Motorlager 8, an dem sich der Antriebsmotor 3 über eine Strebe 11 abstützt, kann dabei gleichfalls zerstört werden. Der Antriebsmotor 3 wird dabei über seine Auspuffkrümmer 12, das Motor- oder Getriebegehäuse oder andere Antriebskomponenten an der Gleitfläche 10 entlang nach unten verschoben, ohne in die Fahrgastzelle einzudringen.

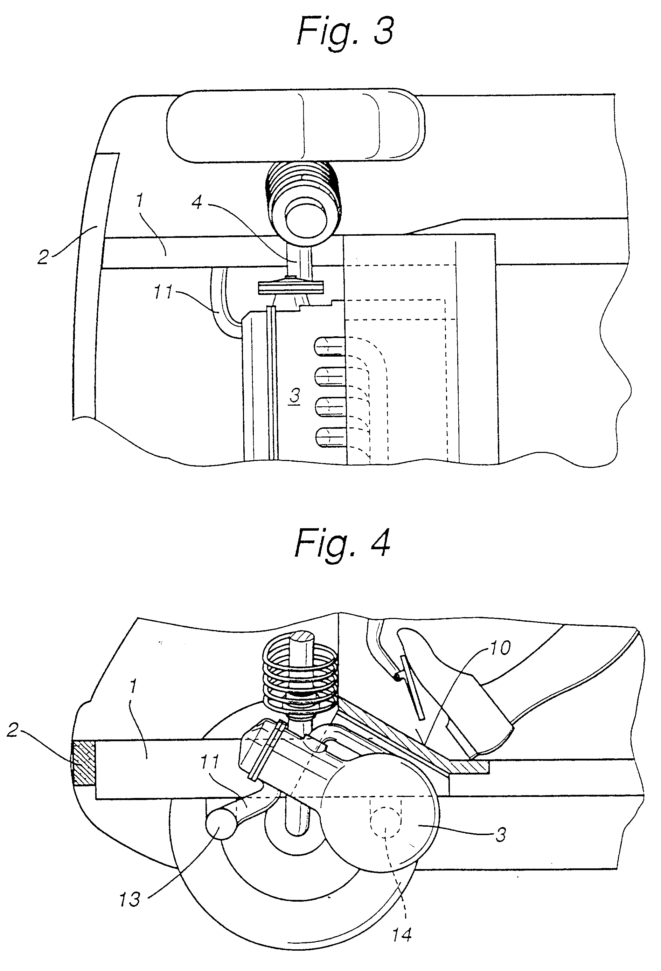

Bei dem in Fig. 4 der Zeichnung dargestellten Ausführungbeispiel der Erfindung ist der Antriebsmotor 3 unter Wegfall des Hilfsrahmens über ein vorderes Motorlager 13 unter Zwischenschaltung der Strebe 11 und ein hinteres Motorlager 14 direkt am Vorbaulängsträger 1 gelagert. Bei einem Crash wird hier nur das hintere Motorlager 14 zerstört bzw. klinkt aus, und der Antriebsmotor wird wie beim vorstehend beschriebenen Ausführungsbeispiel nach unten ohne Blockbildung verschoben.

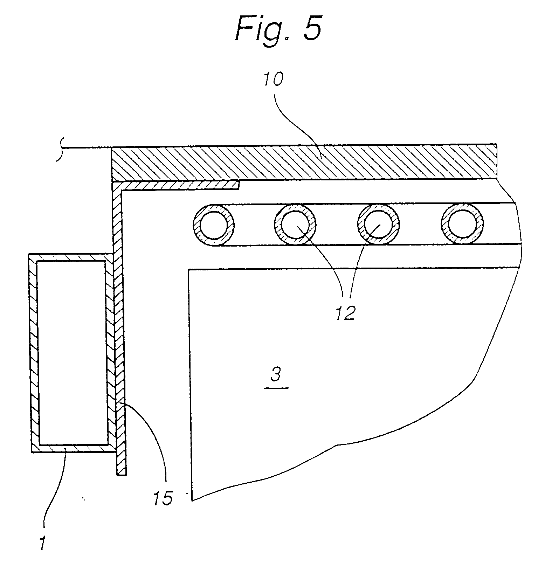

Wie schließlich Fig. 5 der Zeichnung zeigt, können zur zusätzlichen Versteifung Vorbaulängsträger 1 und Gleitfläche 10 durch eine abgewinkelte Platte 15 verbunden sein, die eine Primärkontaktfläche bildet.

Wichtig ist auf jeden Fall, daß die Teile des Antriebsmotors, die zuerst mit der Gleitfläche bzw. der Primärkontaktfläche in Berührung kommen, möglichst glattflächig und ohne vorstehende Kanten oder dergleichen ausgebildet sind, um ein einwandfreies Abgleiten des Antriebsmotors nach unten zu erleichtern.

## Patentansprüche

1. Anordnung eines in einem Kraftwagen eingebauten Antriebsmotors (3), bei der der Antriebsmotor (3) in Fahrtrichtung um einen spitzen Winkel (α) gegen die Horizontale nach unten geneigt eingebaut und über vordere und hintere Motorlager (8, 9; 13, 14) mit dem Fahrzeug verbunden ist, wobei die Motorlager so ausgebildet bzw. dimensioniert sind, daß bei einem Frontalaufprall der Antriebsmotor (3) unter Zerstörung der hinteren Motorlager (9; 14) eine geführte Ausweichbewegung zur Fahrbahn hin ausführt und dem Antriebsmotor (3) ein nach hinten unten weisender Bereich einer Stirnwand zugeordnet ist, wobei der Antriebsmotor (3) so eingebaut ist, daß wesentliche Bereiche des Antriebsmotors (3) hinter der Vorderachse (4) verlaufen, und der nach hinten unten weisende Bereich der Stirnwand als ebene und steife Gleitfläche (10) für den bei einem Frontalaufprall nach hinten sich verschiebenden Antriebsmotor (3) ausgebildet ist und weiterhin die vorderen Motorlager (8; 13) bzw. Lagerstellen (6) eines den Antriebsmotor (3) tragenden Hilfsrahmens (5) so ausgebildet bzw. dimensioniert sind, daß bei einem Frontalaufprall der Antriebsmotor (3) über die vorderen Motorlager bzw. Lager des den Antriebsmotor (3) tragenden Hilfsrahmens (5) mit dem Fahrzeug verbunden bleibt und dabei die Bodenfreiheit des Kraftwagens so gewählt ist, daß der Antriebsmotor (3) bei einem Frontalaufprall vollständig unter den Kraftwagen geschoben werden kann.

2. Anordnung nach Anspruch 1,
**dadurch gekennzeichnet,**
daß die Gleitfläche (10) verstärkt, z.B. doppelschalig oder als Sandwichstruktur, ausgebildet ist.

3. Anordnung nach den Ansprüchen 1 oder 2,
**dadurch gekennzeichnet,**
daß Vorbaulängsträger (1) und Gleitfläche (10) durch eine abgewinkelte Platte (Primärkontaktfläche 15) miteinander verbunden sind.

4. Anordnung nach einem oder mehreren der vorangegangenen Ansprüche,
**dadurch gekennzeichnet,**
daß der Antriebsmotor (3) als quer eingebauter Hubkolbenmotor mit in Reihe angeflanschtem Getriebe ausgebildet ist.

5. Anordnung nach Anspruch 4,
**dadurch gekennzeichnet,**
daß die Zylinderachsen des als Reihenmotor ausgebildeten Hubkolbenmotors unter einem nach vorn offenen Winkel von etwa 30° zur Horizontalen geneigt verlaufen.

## Claims

1. An arrangement of a drive engine (3) mounted in a motor vehicle in which the drive engine (3) is fitted at an acute downwards angle (α) to the horizontal in the direction of travel and is connected to the vehicle by means of front and rear engine mounts (8, 9; 13, 14), whereby the engine mounts are designed or dimensioned in such a way that in the event of a front-end impact the drive engine (3) is deflected towards the road surface thus destroying the rear engine mount (9; 14), and the drive engine (3) is paired with a rearwards and downwards facing section of a bulkhead, whereby the drive engine (3) is mounted in such a way that significant parts of the drive engine (3) run behind the front axle (4) and the rearwards and downwards facing section of the bulkhead is designed as a flat and rigid sliding surface (10) for the drive engine (3) which moves backwards in the event of a front-end impact and, furthermore, the front engine mounts (8; 13) or bearing positions (6) on the auxiliary frame (5) supporting the drive engine (3) are designed or dimensioned in such a way that in the event of a front-end impact the drive engine (3) remains connected to the vehicle by means of the front engine mounts or the bearings on the auxiliary frame supporting the drive engine (3) and that the ground clearance of the vehicle is selected in such a way that in the event of a front-end impact the drive engine (3) can be pushed completely under the vehicle.

2. An arrangement in accordance with Claim 1,
**characterised in that**
the sliding surface (10) is reinforced, e.g. is double-skinned or has a sandwich structure.

3. An arrangement in accordance with Claims 1 or 2,
**characterised in that**
the front end side member (1) and the sliding surface (10) are connected together by means of an angled plate (primary contact surface 15).

4. An arrangement in accordance with one or more of the preceding claims,
**characterised in that**
the drive engine (3) is designed as a transversally mounted reciprocating engine with in-line flange-mounted transmission.

5. An arrangement in accordance with Claim 4,
**characterised in that**
the axes of the cylinders of the in-line reciprocating engine run at a front-opening angle of approximately 30° to the horizontal.

## Revendications

1. Agencement d'un moteur de propulsion (3) monté dans un véhicule automobile, dans lequel le moteur de propulsion (3) est monté incliné d'un angle aigu (α) vers le bas par rapport à l'horizontale, dans le sens de la marche, et est assemblé au véhicule par l'intermédiaire de supports de moteur avant et arrière (8, 9 ; 13, 14), les supports de moteur étant configurés et dimensionnés de manière qu'en cas de collision frontale, le moteur de propulsion (3) décrive un mouvement d'évitement guidé en direction de la chaussée, avec destruction des supports de moteur arrière (9 ; 14) et de telle manière qu'une région d'un tablier qui pointe vers l'arrière et vers le bas soit combinée au moteur de propulsion (3), le moteur de propulsion (3) étant monté de manière que des zones importantes du moteur de propulsion (3) s'étendent en arrière de l'essieu avant (4), et la région du tablier qui pointe vers l'arrière et vers le bas formant une surface de glissement plane et rigide (10) destinée à recevoir le moteur de propulsion (3) qui se déplace vers l'arrière dans le cas d'une collision frontale, et, par ailleurs, les supports de moteur avant (8 ; 13) ou les supports avant (6) d'un cadre auxiliaire (5) qui porte le moteur de propulsion (3) étant configurés et dimensionnés de manière qu'en réponse à une collision frontale, le moteur de propulsion (3) reste relié au véhicule par l'intermédiaire des supports de moteur avant ou des supports avant du cadre auxiliaire (5) qui porte le moteur de propulsion (3), et la garde au sol du véhicule automobile étant choisie de manière qu'en cas de collision frontale, le moteur de propulsion (3) puisse être repoussé entièrement sous le véhicule.

2. Agencement selon la revendication 1,
caractérisé en ce que la surface de glissement (10) est d'une configuration renforcée, par exemple à double paroi ou à structure stratifiée.

3. Agencement selon la revendication 1 ou 2,
caractérisé en ce que le longeron d'avant-corps (1) et la surface de glissement (10) sont assemblés l'un à l'autre par une plaque coudée (surface de contact primaire 15).

4. Agencement selon une ou plusieurs des revendications précédentes,
caractérisé en ce que le moteur de propulsion (3) est constitué par un moteur à pistons alternatifs monté transversalement, avec boîte de vitesses montée en série par bride.

5. Agencement selon la revendication 4,
caractérisé en ce que les axes de cylindre du moteur à pistons alternatifs, configuré en moteur en ligne, sont inclinés sur l'horizontale d'un angle d'environ 30° s'ouvrant vers l'avant.
